# EUROPÄISCHE PATENTSCHRIFT

(11) **EP 0 636 587 B1**
(45) Veröffentlichungstag und Bekanntmachung des Hinweises auf die Patenterteilung: **11.06.1997**
(21) Anmeldenummer: 94111400.1
(22) Anmeldetag: 21.07.1994
(51) Int. Cl.: C03C 17/36

(54) **Verfahren zur Herstellung einer mit einer Mehrfachschicht versehenen Glasscheibe**
Process for making a glass pane coated with a multilayer
Procédé de fabrication d'un vitrage revêtu à couches multiples

(30) Priorität: 22.07.1993 DE 4324576
(43) Veröffentlichungstag der Anmeldung: 01.02.1995
(73) Patentinhaber: SAINT GOBAIN VITRAGE INTERNATIONAL, 92400 Courbevoie (FR); VEGLA Vereinigte Glaswerke GmbH, D-52066 Aachen (DE)
(72) Erfinder: Schicht, Dr. Heinz, D-06925 Bethau (DE); Januschkewitz, Klaus, D-53773 Hennef (DE); Schindler, Herbert, D-04860 Torgau (DE); Gregorowius, Werner, D-51143 Köln (DE); Schneider, Siegfried, D-01445 Radebeul (DE); Ditzel, Gerhard, D-04860 Welsau (DE); Schmidt, Uwe, D-04895 Falkenberg/Elster (DE)
(74) Vertreter: Biermann, Wilhelm, Dr.-Ing.

(56) Entgegenhaltungen:
- EP-A- 0 229 921
- EP-A- 0 448 522
- EP-A- 0 506 507
- FR-A- 2 641 272
- US-A- 4 790 922
- SOLAR ENERGY MATERIALS, Bd. 19, Nr. 1/2, September 1989 AMSTERDAM NL, Seiten 43-53, J. SZCZYRBOWSKI ET AL

## Beschreibung

Die Erfindung betrifft ein Verfahren zur Herstellung einer mit einer Mehrfachschicht versehenen Glasscheibe mit hoher Transmission im sichtbaren Spektralbereich und hoher Reflexion für Wärmestrahlung, bei dem nach einem Vakuumverfahren eine Schichtenfolge auf die Glasscheibe aufgebracht wird, die eine eine auf der Glasoberfläche angeordnete Grundschicht aus einer Metallverbindung und eine darauffolgende Metalloxidschicht umfassende untere Entspiegelungsschicht, eine auf dieser unteren Entspiegelungsschicht angeordnete Metallschicht, eine Silberschicht und eine obere Entspiegelungsschicht aus einem Metalloxid umfaßt.

Ein Verfahren dieser Art ist aus der EP 0448522 A3 bekannt. Bei diesem Verfahren wird zur Herstellung einer Kraftfahrzeug-Windschutzscheibe, die sowohl Sonnenschutzfunktion hat als auch gleichzeitig als Combiner für ein Head-up-Display verwendbar ist, auf die Glasoberfläche nach dem Verfahren der Kathodenzerstäubung zunächst eine eine Grundschicht aus TiO₂ aufgebracht, die zusammen mit einer darauffolgenden Schicht aus Al₂O₃ oder SiO₂ die untere Entspiegelungsschicht bildet. Eines der in diesem Dokument beschriebenen Schichtsysteme umfaßt auch eine metallische Schicht aus Al unterhalb der Silberschicht, jedoch ist oberhalb der Silberschicht keine metallische Schutzschicht vorgesehen. Für hohe thermische Belastungen sind die in diesem Dokument beschriebenen Schichtsysteme deshalb nicht geeignet.

Wenn beschichtete Glasscheiben eine hohe Beständigkeit bei thermischen Belastungen und eine hohe Langzeitbeständigkeit aufweisen sollen, ist es zweckmäßig und bekannt, auch unmittelbar auf der Silberschicht eine metallische Schutzschicht anzuordnen. Glasscheiben mit einem solchen Schichtaufbau sind aus den Druckschriften DE-A-3543178, DE-A-3544840, DE-A-3825671 und DE-A-3728478, sowie EP-A-0224704, EP-A-0303109 und EP-A-0506507 bekannt. Von den bekannten Schichtaufbauten haben sich aus praktischen Gründen insbesondere solche bewährt, bei denen die untere und die obere Entspiegelungsschicht jeweils aus Zinnoxid oder Zinkoxid, und die metallischen Schutzschichten aus Nickel, Chrom oder einer Nickel-Chrom-Legierung, oder aus Zinn bestehen. Glasscheiben mit derartigen Mehrfachschichten weisen eine hohe Langzeitbeständigkeit und eine hohe Beständigkeit bei thermischen Belastungen auf. Insbesondere eignen sie sich auch zum Biegen und/oder zum Vorspannen. Zu diesem Zweck müssen die beschichteten Glasscheiben nämlich auf eine verhältnismäßig hohe Temperatur von etwa 650 Grad Celsius erwärmt werden, was an die Mehrfachschicht, bei der die eigentliche Funktionsschicht aus einer dünnen Silberschicht besteht, besonders hohe Anforderungen stellt.

Aus der EP-A-0229921 ist es bekannt, bei einem Mehrfachschichtsystem die untere Entspiegelungsschicht als Schichtenfolge aus zwei verschiedenen Oxiden aus der Gruppe Zinnoxid, Siliziumoxid, Aluminiumoxid, Tantaloxid oder Zirkoniumoxid auszuführen. Hinweise auf mögliche Vorteile einer solchen in sich inhomogenen Entspiegelungsschicht finden sich in dieser Druckschrift nicht.

Auch aus der US-PS 4.790.922 ist ein für die Herstellung vorgespannter Glasscheiben geeignetes Schichtsystem bekannt. Bei diesem Schichtsystem besteht die untere Entspiegelungsschicht aus einer Mischung aus Zinnoxid und Zinkoxid, und die beiden Metallschichten beiderseits der Silberschicht bestehen aus Titan.

Biegbare Fünfschichtsysteme sind auch aus der Veröffentlichung "Bendable Silber-Based Low Emissivity Coating on Glass", Z. Solar Energy Materials Bd. 19, Nr. 1/2 September 1989 bekannt. Die untere Entspiegelungsschicht besteht bei diesem Schichtsystem aus Zinnoxid und ist unmittelbar auf der Glasoberfläche angeordnet.

Aus der FR-A-2.641.272 sind Mehrfachschichtsysteme mit einer Silberschicht bekannt, bei denen als unterste Schicht unmittelbar auf der Glasoberfläche eine Schicht aus TiO₂ angeordnet ist, die zusammen mit einer anderen Oxidschicht die untere Entspiegelungsschicht bildet. Die TiO₂-Schicht soll insbesondere eine gute Verbindung zur Glasoberfläche herstellen. Bei den in diesem Dokument beschriebenen Schichtsystemen ist nur oberhalb der Silberschicht eine metallische Schutzschicht angeordnet, so daß diese Schichtsysteme für hohe thermische Belastungen nicht geeignet sind.

Auch bei den bekannten Mehrfachschichtsystemen mit metallischen Schutzschichten oberhalb und unterhalb der Silberschicht kann es bei starker thermischer Belastung der Glasscheiben, nämlich beim Biegen und/oder beim thermischen Vorspannen, gelegentlich zu sichtbaren Schichtveränderungen kommen. Insbesondere kann die Schicht unter dem Einfluß der hohen Temperatur ein mattes, fleckiges Aussehen bekommen. Ferner können gelegentlich Risse, Trübungen oder Verfärbungen der Schicht nach einer solchen Wärmebehandlung beobachtet werden. Als Ursache für derartige Schichtveränderungen wird in der Fachwelt eine Störung während des Beschichtungsprozesses angenommen, was zu einem fehlerhaften Schichtaufbau führt.

Der Erfindung liegt die Aufgabe zugrunde, die Qualität von Mehrfachschichten weiter zu verbessern. Insbesondere soll die Stabilität der Mehrfachschicht weiter erhöht werden, damit sie auch bei vorhandenen Störungen im strukturellen Aufbau der Schichten hohe Temperaturbelastungen, wie sie beispielsweise beim Biegen und/oder Vorspannen der Glasscheiben auftreten, ohne nachteilige Veränderungen der Schicht übersteht.

Gemäß der Erfindung wird diese Aufgabe dadurch gelöst, daß die unmittelbar auf der Glasoberfläche angeordnete Grundschicht aus einem Oxid, Nitrid, Oxinitrid, Karbid oder Borid eines oder mehrerer der Elemente Hf, V, Nb, Cr, Mo, W, Mn, Fe, Zn, As, Sb und In, oder aus deren Mischverbindungen, oder aus einer der Verbindungen Si₃N₄, TiN, ZrN, TiₓC, ZrB₂, Almnoₓ, AlcrOₓ, AlVO_{X} und AlSiOₓ abgeschieden wird.

Durch diese unmittelbar auf der Oberfläche der Glasscheibe angeordnete Grundschicht, die verhältnismäßig dünn sein kann und 1 bis 10 nm betragen soll, wird offensichtlich ein wesentlicher Schutz der Mehrfachschicht erreicht. Bei dieser Grundschicht handelt es sich erfindungsgemäß um eine Verbindung mit saurem oder amphoterem Charakter. Grundschichten aus einer Verbindung mit basischem Charakter führen, wie entsprechende Versuche gezeigt haben, nicht zu dem gewünschten Ergebnis.

An Schichtsystemen nach dem Stand der Technik und an erfindungsgemäßen Schichtsystemen durchgeführte Untersuchungen lassen den Schluß zu, daß eine wesentliche Ursache für die gelegentlich zu beobachtenden Schichtveränderungen nach einer starken Wärmebelastung der Schicht darin gesehen werden kann, daß die untere Entspiegelungsschicht bei nach dem Stand der Technik aufgebauten Schichtsystemen mit dem Natriumoxid aus der Glasoberfläche reagiert und dadurch eine strukturelle Umwandlung erfährt. Offenbar dringen bei hohen Temperaturen die aus dem Glas stammenden Natriumionen in die amorphe Metalloxidschicht ein, wo sie die genannten Strukturumwandlungen und Veränderungen bewirken.

Möglicherweise kommt es dabei sogar zur Ausbildung kristalliner Bereiche und zu einer Veränderung des Molvolumens und anderer spezifischer Kenngrößen der unteren Entspiegelungsschicht, was zu der beobachteten Qualitätsverschlechterung führen kann.

Durch die erfindungsgemäße Ausbildung der Grundschicht wird unmittelbar auf der Glasoberfläche eine Schicht erzeugt, die offenbar die Funktion einer Diffusions-Sperrschicht hat. Diese Grundschicht ist aufgrund ihrer Zusammensetzung in der Lage, in diese Schicht eindiffundierende Natriumionen chemisch zu binden und außerdem zu verhindern, daß Natriumionen durch diese Grundschicht hindurchdiffundieren.

In diesem Zusammenhang ist es von besonderer Bedeutung, daß die Grundschicht Bestandteile mit saurem Charakter enthält, die mit dem basischen Natriumoxid eine feste chemische Verbindung eingehen. Da auf diese Weise die Diffusion von Natriumionen in die untere Entspiegelungsschicht hinein unterbunden oder zumindest stark gehemmt wird, kommt es nicht mehr zu den genannten störenden Schichtveränderungen weder innerhalb der unteren Entspiegelungsschicht noch in den nachfolgenden Schichten.

Der Erfindung liegt also auch die Erkenntnis zugrunde, daß die bei thermischer Belastung bei beschichteten Glasscheiben nach dem Stand der Technik beobachteten Schichtveränderungen entgegen den bisherigen Annahmen nicht nur durch Reaktionen von Schichtbestandteilen mit Sauerstoff aus der Umgebungsatmosphäre oder mit innerhalb der Schichten vorhandenen Sauerstoffatomen oder -molekülen erfolgen, sondern daß wesentliche Veränderungsvorgänge innerhalb des Schichtsystems eine andere Ursache haben als bisher allgemein angenommen wurde.

In zweckmäßiger Weiterbildung der Erfindung läßt sich eine noch weitergehende Verbesserung der Schichtqualität erreichen, wenn die Glasscheibe vor dem Aufbringen der Grundschicht in einer der Beschichtungsanlage vorgelagerten Behandlungsstation mit einer verdünnten Säure, insbesondere verdünnter Essigsäure, mit einem pH-Wert von 4 - 6,5 behandelt und gewaschen wird. Dabei wird offenbar ein Teil der Natriumionen an der Glasoberfläche durch die Säure gebunden, und die Reaktionsprodukte werden beim Waschvorgang entfernt.

Ebenso läßt sich ein weiterer günstiger Einfluß auf die Schichtqualität erreichen, wenn die Glasscheibe vor dem Aufbringen der Grundschicht statt mit einer Säure mit einer wässrigen Zinnchloridlösung mit 0,5 bis 1 Gew.-% SnCl₂ behandelt wird. In diesem Fall läßt sich der günstige Einfluß auch dann beobachten, wenn die Zinnchloridlösung durch Zusatz einer Base einen pH-Wert von > 7 aufweist. Durch die Behandlung mit einer solchen Zinnchlorid enthaltenden Lösung erfolgt durch chemische Reaktion anscheinend eine Verdichtung der an der Glasoberfläche vorhandenen Gelschicht, wodurch ebenfalls die Konzentration der freien Natriumionen an der Glasoberfläche und/oder ihre Beweglichkeit verringert wird.

In vorteilhafter Weiterbildung des erfindungsgemäßen Verfahrens wird die Grundschicht in stöchiometrischer Zusammensetzung aufgebracht. Versuche haben gezeigt, daß auf diese Weise die Wirksamkeit der Grundschicht als Natriumfänger und als Diffusionssperre für Natriumionen am besten ist. Offenbar hat eine stöchiometrische Verbindung einen stärker sauren Charakter als eine unterstöchiometrische Zusammensetzung, so daß eine solche stöchiometrische Grundschicht eine größere Bindungsfähigkeit für die Natriumionen aufweist.

Besondere Bedeutung hat das erfindungsgemäße Verfahren, wenn die Mehrfachschicht nach dem Verfahren der magnetfeldunterstützten reaktiven Kathodenzerstäubung aufgebracht wird. Moderne leistungsfähige Beschichtungsanlagen für Glasscheiben arbeiten heute nach diesem Verfahren, das sich in kontinuierlich arbeitenden Durchlaufanlagen durchführen läßt. Moderne Anlagen dieser Art verfügen über eine genügende Anzahl von Kathodenplätzen, so daß die erfindungsgemäße zusätzliche Grundschicht ohne Schwierigkeiten mit solchen Anlagen aufgebracht werden kann. Dabei wird das Verfahren zum Aufbringen der Grundschicht vorzugsweise reaktiv geführt, so daß reine Metalltargets hierfür zum Einsatz kommen können und die Erzeugung der Metallverbindung durch genaue Einstellung der Zusammensetzung des Arbeitsgases und der übrigen Verfahrensparameter vorgenommen wird.

Nachfolgend wird die Erfindung anhand eines Vergleichsbeispiels und verschiedener Ausführungsbeispiele näher erläutert. Für die Versuche wurden 4 mm dicke Floatglasscheiben in einer magnetfeldunterstützten Kathodenzerstäubungsanlage beschichtet. Die beschichteten Floatglasscheiben der Größe 15 x 30 cm wurden dann einem thermischen Vorspannprozeß unterworfen, das heißt sie wurden auf etwa 650 Grad Celsius an Luft erwärmt und anschließend durch schroffe Abkühlung mit Hilfe von Luftstrahlen schnell abgekühlt. Die Auswertung der Versuche erfolgte einerseits durch visuelle Beurteilung der Glasscheiben, und andererseits durch Messung der Transmissions- und Reflexionseigenschaften.

### Vergleichsbeispiel

Zehn Floatglasscheiben der Größe 15 x 30 cm wurden nach gründlicher Reinigung in einer nach dem Verfahren der magnetfeldunterstützten Kathodenzerstäubung arbeitenden Anlage mit einem Wärmeschutz-Schichtsystem mit folgendem Schichtaufbau beschichtet:

| | | |
|---|---|---|
| - untere Entspiegelungsschicht | SnO₂ | 40 nm |
| - Metallschicht | Sn | 0,7 nm |
| - Silberschicht | Ag | 9 nm |
| - Metallschicht | CrNi 20/80 | 7,5 nm |
| - obere Entspiegelungsschicht | SnO₂ | 40 nm |

Die beschichteten Glasscheiben weisen eine Transmission bei 550 nm von 67 % und eine IR-Reflexion bei 8 µm von 90 % auf. Die visuelle Beurteilung ergibt ein einwandfreies Aussehen der Schicht bei allen zehn Versuchsscheiben.

Nach dem thermischen Vorspannen ist die Transmission bei 550 nm infolge Oxidation der oberen Metallschicht auf 83 % gestiegen. Die IR-Reflexion beträgt unverändert 90 %.

Die visuelle Beurteilung ergibt, daß fünf der zehn Versuchsscheiben Fehler in der Schicht aufweisen, und zwar in Form von kleinen Haarrissen, Trübungserscheinungen und blauen Flecken.

### Ausführungsbeispiel 1

Auf zehn Versuchsscheiben aus Floatglas mit denselben Abmessungen wie beim Vergleichsbeispiel wurde nach gründlicher Reinigung, anschließender Behandlung mit verdünnter Essigsäure mit einem PH-Wert von 4 und erneuter gründlicher Reinigung in einer Waschmaschine eine 2 nm dicke stöchiometrische Cr₂O₃-Schicht nach dem Verfahren der reaktiven Kathodenzerstäubung unter Verwendung eines metallischen Chrom-Targets aufgebracht. Anschließend wurde auf diese Grundschicht dasselbe Schichtsystem aufgebracht wie beim Vergleichsbeispiel.

Die Messungen der Transmission bei 550 nm und der IR-Reflexion bei 8 µm der so beschichteten Glasscheiben ergaben die gleichen Werte wie bei dem Vergleichsbeispiel.

Die beschichteten Versuchsscheiben wurden unter denselben Bedingungen auf ihre Vorspanntemperatur erwärmt und durch Aufblasen von Kühlluft thermisch vorgespannt wie die Glasscheiben des Vergleichsversuchs. Anschließend wurden wieder die Transmissionswerte und die Reflexionswerte bestimmt, die ebenfalls in demselben Bereich lagen wie bei den vorgespannten Glasscheiben des Vergleichsbeispiels. Die visuelle Beurteilung ergab jedoch, daß alle zehn Versuchsscheiben eine sehr gute optische Qualität aufweisen, das heißt vollständig frei von sichtbaren Beeinträchtigungen oder Fehlern der Schicht waren.

### Ausführungsbeispiel 2

Zehn Floatglasscheiben mit den gleichen Abmessungen wie beim Vergleichsbeispiel wurden nach gründlicher Reinigung in einer Magnetronanlage mit einer 5 nm dicken Grundschicht aus TiN beschichtet. Die Schichtbildung erfolgte nach dem Verfahren der reaktiven Kathodenzerstäubung mit Hilfe eines metallischen Titan-Targets und in einer Ar/N₂-Arbeitsgasatmosphäre. Anschließend wurde unter Wechsel des Arbeitsgases auf diese Grundschicht dasselbe Schichtsystem aufgebracht wie beim Vergleichsbeispiel.

Die beschichteten Glasscheiben weisen eine Transmission von 65 % bei einer Wellenlänge von 550 nm, und eine IR-Reflexion von 90 % bei einer Wellenlänge von 8 µm auf. Alle zehn beschichteten Glasscheiben hatten ein einwandfreies Aussehen, und die Schichten waren frei von Fehlern.

Die beschichteten Glasscheiben wurden sodann unter denselben Bedingungen auf die Vorspanntemperatur erwärmt und thermisch vorgespannt wie die Glasscheiben des Vergleichsversuchs. Anschließend wurden wieder die Transmissionswerte und die Reflexionswerte bestimmt. Die Transmission bei 550 nm war infolge oxidativer Umwandlungsprozesse im Schichtsystem auf 82 % gestiegen. Die IR-Reflexion betrug unverändert 90 %.

Die visuelle Beurteilung ergab, daß alle zehn Versuchsscheiben ein völlig einwandfreies Aussehen nach dem Vorspannprozeß aufwiesen, also vollständig frei von sichtbaren Beeinträchtigungen oder Fehlern der Schicht waren.

### Ausführungsbeispiel 3

Weitere zehn Floatglasscheiben mit den im Vergleichsbeispiel genannten Abmessungen wurden nach gründlicher Reinigung mit einer 0,5 Gew.-%igen wässrigen SnCl₂-Lösung mit einem pH-Wert von 5 behandelt. Danach wurden sie in einer Waschmaschine erneut gründlich gereinigt. Anschließend wurde in einer Magnetronanlage durch reaktive Zerstäubung eines Targets aus einer Aluminium-Mangan-Legierung in einer Ar/02-Arbeitsgasatmosphäre eine 2 nm dicke Schicht eines Aluminium-Mangan-Mischoxids (x Al₂O₃ y Mn₂O₃) als Grundschicht auf der Glasoberfläche abgeschieden. Auf diese Grundschicht wurde das gleiche Schichtsystem wie im Vergleichsbeispiel in der Magnetronanlage abgeschieden.

Die so beschichteten Glasscheiben wiesen eine Transmission von 65 % bei 550 nm, und eine IR-Reflexion von 90 % bei 8 µm auf. Alle beschichteten Scheiben hatten ein einwandfreies Aussehen und waren frei von Fehlern.

Die beschichteten Glasscheiben wurden unter denselben Bedingungen auf die Vorspanntemperatur erwärmt und durch schroffe Kühlung mit Luftstrahlen vorgespannt wie die Glasscheiben bei dem Vergleichsbeispiel. Anschließend wurden wieder die Transmissionswerte und die Reflexionswerte bestimmt. Die gemessenen Werte lagen wiederum bei 82 % für die Transmsission und bei unverändert 90 % für die IR-Reflexion.

Die visuelle Beurteilung ergab bei allen zehn Scheiben eine sehr gute optische Qualität, das heißt alle vorgespannnten beschichteten Glasscheiben waren frei von sichtbaren Beeinträchtigungen jeder Art.

### Ausführungsbeispiel 4

Zehn Floatglasscheiben mit den im Vergleichsbeispiel genannten Abmessungen wurden in einer Waschmaschine gründlich gereinigt und danach mit einer 2 nm dicken Grundschicht aus einem Aluminium-Silizium-Mischoxid (x Al₂O₃·y SiO₂) in einem reaktiven Magnetronprozeß versehen. Als Target wurde ein AlSi-Target verwendet, und als Arbeitsgas diente eine Ar/O₂-Atmosphäre. Auf diese Grundschicht wurde anschließend das gleiche Schichtsystem wie im Vergleichsbeispiel in der Magnetronanlage aufgebracht.

Die beschichteten Glasscheiben hatten bei einer Wellenlänge von 550 nm eine Transmission von 67 %, und bei einer Wellenlänge von 8 µm eine IR-Reflexion von 90 %. Alle Scheiben hatten bei visueller Betrachtung eine ausgezeichnete Qualität.

Die beschichteten Glasscheiben wurden in gleicher Weise wie im Vergleichsbeispiel thermisch vorgespannt. Nach dem Vorspannen betrug die Transmission bei 550 nm infolge oxidativer Umwandlungen im Schichtsystem 83 %; die IR-Reflexion betrug unverändert 90 %.

Die visuelle Beurteilung ergab bei allen Versuchsscheiben, daß die ausgezeichnete optische Qualität der Schicht keine Beeinträchtigung durch den Vorspannprozeß erfahren hatte.

## Patentansprüche

1. Verfahren zur Herstellung einer mit einer Mehrfachschicht versehenen Glasscheibe mit hoher Transmission im sichtbaren Spektralbereich und hoher Reflexion für Wärmestrahlung, bei dem nach einem Vakuumverfahren eine Schichtenfolge auf die Glasscheibe aufgebracht wird, die eine eine auf der Glasoberfläche angeordnete Grundschicht aus einer Metallverbindung und eine darauffolgende Metalloxidschicht umfassende untere Entspiegelungsschicht, eine auf der unteren Entspiegelungsschicht angeordnete Metallschicht, eine Silberschicht und eine obere Entspiegelungsschicht umfaßt, **dadurch gekennzeichnet,** daß die unmittelbar auf der Glasoberfläche angeordnete Grundschicht aus einem Oxid, Nitrid, Oxinitrid, Karbid oder Borid eines oder mehrerer der Elemente Hf, V, Nb, Cr, Mo, W, Mn, Fe, Zn, As, Sb und In, oder aus deren Mischverbindungen, oder aus einer der Verbindungen Si₃N₄, TiN, ZrN, TiₓC, ZrB₂, AlMnoₓ, AlCrOₓ, AlVO_{X} und AlsiOₓ abgeschieden wird.

2. Verfahren nach Anspruch 1, dadurch gekennzeichnet, daß die Grundschicht mit einer geometrischen Dicke von 1 bis 10 nm aufgebracht wird.

3. Verfahren nach Anspruch 1 oder 2, dadurch gekennzeichnet, daß die Grundschicht in stöchiometrischer Zusammensetzung aufgebracht wird.

4. Verfahren nach Anspruch 1 bis 3, dadurch gekennzeichnet, daß die Grundschicht aus Cr₂O₃ besteht.

5. Verfahren nach einem der Ansprüche 1 bis 4, dadurch gekennzeichnet, daß die Glasscheibe vor dem Aufbringen der Grundschicht mit verdünnter Säure, wie verdünnter Essigsäure, mit einem pH-Wert von 4 bis 6,5 behandelt wird.

6. Verfahren nach einem der Ansprüche 1 bis 4, dadurch gekennzeichnet, daß die Glasscheibe vor dem Aufbringen der Grundschicht mit einer wässrigen Zinnchloridlösung behandelt wird.

## Claims

1. A method for the production of a glass plate provided with a composite layer having a high transmission factor in the visible spectral range and a high reflection factor for thermal radiation, in the case of which using a vacuum method a layer sequence is applied to the glass plate, such layer sequence comprising a lower anti-reflection layer comprising a basic layer arranged on the glass surface and being made up of a metal compound, and a metal oxide layer following same a metal layer arranged on the lower anti-reflection layer, a silver layer and an upper anti-reflection layer,
characterized in that the basic layer arranged directly on the glass surface is formed by an oxide, nitride, oxynitride, carbide or boride of one of more of the elements Hf, V, Nb, Cr, Mo, W, Mn, Fe, Zn, As, Sb and In, or by mixed compounds thereof, or by one of the compounds Si₃N₄, TiN, ZrN, TiₓC, ZrB₂, ZrB₂, AlMnOₓ, AlCrOₓ, AlVOₓ and AlSiOₓ.

2. The method as claimed in claim 1, characterized in that the basic layer is applied with a geometrical thickness of 1 to 10 nm.

3. The method as claimed in claim 1 or in claim 3, characterized in this the basic layer is applied in stoichiometric composition.

4. The method as claimed in any one of the claims 1 through 3, characterized in that the basic layer consists of Cr₂O₃.

5. The method as claimed in any one of the claims 1 through 4, characterized in that prior to the application of the basic layer the glass plate is treated with a diluted acid such as acetic acid, with a pH value of 4 through 6.5.

6. The method as claimed in any one of the claims 1 through 4, characterized in that the prior to the application of the basic layer the glass plate is treated with an aqueous zinc chloride solution.

## Revendications

1. Procédé de fabrication d'un vitrage pourvu d'une couche multiple présentant une transmission élevée dans le domaine du spectre visible et une réflexion élevée pour le rayonnement thermique, dans lequel est déposée sur le vitrage par un procédé sous vide une succession de couches qui comprend une couche de fond en un composé métallique disposée sur la surface du verre suivie d'une couche antireflet inférieure comprenant un oxyde métallique, une couche métallique disposée sur la couche antireflet inférieure, une couche d'argent et une couche antireflet supérieure, caractérisé en ce que la couche de fond disposée directement sur la surface de verre est formée d'un oxyde, d'un nitrure, d'un oxynitrure, d'un carbure ou d'un borure d'un ou de plusieurs des éléments Hf, V, Nb, Cr, Mo, W, Mn, Fe, Zn, As, Sb et In, ou de leurs composés de mélange, ou de l'un des composés Si₃N₄, TiN, ZrN, TiₓC, ZrB₂, AlMnOₓ, AlCrOₓ, AlVOₓ et AlSiOₓ.

2. Procédé suivant la revendication 1, caractérisé en ce que la couche de fond est déposée en une épaisseur géométrique de 1 à 10 nm.

3. Procédé suivant la revendication 1 ou 2, caractérisé en ce que la couche de fond est déposée avec une composition stoechiométrique.

4. Procédé suivant les revendications 1 à 3, caractérisé en ce que la couche de fond est constituée de Cr₂O₃.

5. Procédé suivant l'une quelconque des revendications 1 à 4, caractérisé en ce que le vitrage est traité avant le dépôt de la couche de fond au moyen d'un acide dilué, tel que de l'acide acétique dilué, à une valeur de pH de 4 à 6,5.

6. Procédé suivant l'une quelconque des revendications 1 à 4, caractérisé en ce que le vitrage est traité avant le dépôt de la couche de fond au moyen d'une solution aqueuse de chlorure stanneux.
